# EUROPEAN PATENT APPLICATION

(11) **EP 4 764 560 A1**
(43) Date of publication of application: **24.06.2026**
(21) Application number: 25223604.7
(22) Date of filing: 15.12.2025
(51) Int. Cl.: G01R 31/396, G01R 31/52, H01M 10/48

(54) **METHOD AND SYSTEM FOR DETECTING INTER-CELL SHORT CIRCUITS IN SECONDARY BATTERIES**

(30) Priority: 17.12.2024 KR 20240189307
(71) Applicant: Samsung SDI Co., Ltd., Yongin-si, Gyeonggi-do 17084 (KR)
(72) Inventor: SON, Seongbo, 17084 Yongin-si (KR); JANG, Seongyong, 17084 Yongin-si (KR); CHEON, Bohyun, 17084 Yongin-si (KR)
(74) Representative: Marks & Clerk LLP

(57) **Abstract**

Disclosed herein are a method and system for detecting inter-cell short circuits in secondary batteries. The system includes a voltage measurement unit including a probe that comes into contact with a cell of a secondary battery to measure an inter-cell voltage, a short-circuit control unit configured to control an inter-cell short circuit, and an inter-cell short-circuit detection unit configured to measure a first voltage between a first cell and a second cell in the secondary battery, to create a short circuit between the first and second cells, to measure a second voltage between the first and second cells, to eliminate the short circuit between the first and second cells, to measure a third voltage between the first and second cells, and to determine whether a short circuit occurs between the first and second cells by using at least one of the first to third voltages.

## Description

### BACKGROUND

### 1. Technical Field

The present disclosure relates to a method and system for detecting inter-cell short circuits in secondary batteries, and more particularly, to a method and system for detecting inter-cell short circuits in secondary batteries, which are capable of determining whether a short circuit occurs between cells in a secondary battery module through can-to-can voltage measurement.

### 2. Related Art

Unlike primary batteries that are not designed to be charged, secondary batteries are designed to be discharged and recharged. Low-capacity secondary batteries are used in small portable electronic devices, such as smart phones, feature phones, notebook computers, digital cameras, and camcorders, while large-capacity secondary batteries are widely used as power sources for driving motors, such as of hybrid vehicles or electric vehicles, batteries for power storage, or the like. In general, each individual secondary battery includes an electrode assembly assembled with a positive electrode, a negative electrode, and a separator interposed therebetween. The assembled electrode assembly is mounted in a battery casing and an electrolyte is injected thereinto so as to manufacture a battery cell.

Among the secondary batteries, lithium secondary batteries are utilized in various fields due to their excellent electrical properties. However, these lithium secondary batteries may have low safety. For example, the lithium secondary batteries may often be ignited or exploded under abnormal conditions of operation, such as overcharge, overdischarge, exposure to high temperatures, or electrical short circuits. Specifically, heat and gas are generated when components of battery cells, such as active materials or electrolytes, undergo a decomposition reaction. The generated heat and gas increase the temperature and pressure inside the battery cells. The increased temperature and pressure further accelerate the decomposition reaction, which may eventually lead to ignition or explosion.

Therefore, it is very important to ensure the safety of the battery cells, and one way to do so is to evaluate the safety of battery cells when a short circuit occurs between the battery cells. In particular, there is a need for technology to determine whether a short circuit occurs between battery cells.

Examples of conventional methods for detecting short circuits between battery cells include a withstand voltage measurement method, a resistance measurement method, and a cell voltage measurement method. The withstand voltage (insulation resistance) measurement method makes it impossible to detect a short circuit between cells since it measures the current that leaks when high voltage is applied to a module. The resistance measurement method may not ensure reliable results due to large deviation in measurement of resistance by battery electromotive force. The cell voltage measurement method makes it possible to detect a short circuit between cells only when a cell voltage drop occurs due to the short circuit between cells since it measures the voltage between cell terminals, and may take a long time to detect the short circuit between cells as the cell voltage drop takes several months or more depending on the short-circuit resistance between cells.

The above information disclosed in this Background section is for enhancement of understanding of the background of the present disclosure, and therefore, it may contain information that does not constitute related (or prior) art.

### SUMMARY

Accordingly, an object of the present disclosure is to provide a method and system for detecting inter-cell short circuits in secondary batteries, which are capable of determining whether there is an inter-cell short circuit by measuring a can-to-can voltage through a change of state by metallic unique objects during assembly of secondary battery modules.

However, the technical problem to be solved by the present disclosure is not limited to the above problem, and other problems not mentioned herein, and aspects and features of the present disclosure that would address such problems, will be clearly understood by those skilled in the art from the description of the present disclosure below.

In accordance with an aspect of the present disclosure, there is provided a system for detecting inter-cell short circuits in secondary batteries, which includes a voltage measurement unit configured to include a probe that comes into contact with a cell of a secondary battery to measure an inter-cell voltage, a short-circuit control unit configured to control an inter-cell short circuit, and an inter-cell short-circuit detection unit configured to control the voltage measurement unit to measure a first voltage between a first cell and a second cell in the secondary battery, to control the short-circuit control unit to create a short circuit between the first cell and the second cell, to control the voltage measurement unit to measure a second voltage between the first cell and the second cell, to control the short-circuit control unit to eliminate the short circuit between the first cell and the second cell, to control the voltage measurement unit to measure a third voltage between the first cell and the second cell, and to determine whether a short circuit occurs between the first cell and the second cell by using at least one of the first voltage, the second voltage, and the third voltage.

The inter-cell short-circuit detection unit may determine whether a short circuit occurs between the first cell and the second cell based on whether the second voltage falls within a preset cell voltage criterion.

The inter-cell short-circuit detection unit may determine whether a short circuit occurs between the first cell and the second cell based on whether a difference between the first voltage and the second voltage falls within a preset cell voltage criterion.

The inter-cell short-circuit detection unit may determine whether a short circuit occurs between the first cell and the second cell based on whether a difference between the third voltage and the second voltage falls within a preset cell voltage criterion.

The probe may have a " 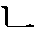 " shape.

The probe may have a "V" shape.

The probe may have a " 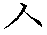 " shape.

The voltage measurement unit may further include a pressure sensor attached to one surface of the probe to measure a pressure applied to one surface of the probe, and a probe controller configured to control the operation of the probe such that the probe comes into contact with the cell at a preset pressure or less.

The probe controller may control the operation of the probe such that the probe comes into contact with a cap plate through a Cell Monitoring Circuit (CMC) hole of a can constituting the cell.

The short-circuit control unit may create a short circuit by adding a specific resistance between the first cell and the second cell.

In accordance with another aspect of the present disclosure, there is provided a method of detecting inter-cell short circuits in secondary batteries, which is performed by a system for detecting inter-cell short circuits in secondary batteries that includes a voltage measurement unit configured to include a probe that comes into contact with a cell of a secondary battery to measure an inter-cell voltage and a short-circuit control unit configured to control an inter-cell short circuit. The method includes controlling the voltage measurement unit to measure a first voltage between a first cell and a second cell in the secondary battery, controlling the short-circuit control unit to create a short circuit between the first cell and the second cell, controlling the voltage measurement unit to measure a second voltage between the first cell and the second cell, controlling the short-circuit control unit to eliminate the short circuit between the first cell and the second cell, controlling the voltage measurement unit to measure a third voltage between the first cell and the second cell, and determining whether a short circuit occurs between the first cell and the second cell by using at least one of the first voltage, the second voltage, and the third voltage.

Whether a short circuit occurs between the first cell and the second cell may be determined based on whether the second voltage falls within a preset cell voltage criterion.

Whether a short circuit occurs between the first cell and the second cell may be determined based on whether a difference between the first voltage and the second voltage falls within a preset cell voltage criterion.

Whether a short circuit occurs between the first cell and the second cell may be determined based on whether a difference between the third voltage and the second voltage falls within a preset cell voltage criterion.

The probe may have a " 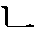 " shape.

The probe may have a "V" shape.

The probe may have a " 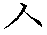 " shape.

The voltage measurement unit may further include a pressure sensor attached to one surface of the probe to measure a pressure applied to one surface of the probe, and a probe controller configured to control the operation of the probe, and the probe controller may control the operation of the probe such that the probe comes into contact with the cell at a preset pressure or less.

The probe controller may control the operation of the probe such that the probe comes into contact with a cap plate through a CMC hole of a can constituting the cell.

The short-circuit control unit may create a short circuit by adding a specific resistance between the first cell and the second cell.

At least some of the above and other features of the invention are set out in the claims.

### BRIEF DESCRIPTION OF THE DRAWINGS

The following drawings attached to the present specification illustrate embodiments of the present disclosure, and further describe aspects and features of the present disclosure together with the detailed description of the present disclosure. Thus, the present disclosure should not be construed as being limited to the drawings:
FIG. 1A is a top perspective view of a prismatic secondary battery;
FIG. 1B is a cross-sectional view taken along line I-I' of FIG. 1A;
FIG. 2 is a block diagram of a system for detecting inter-cell short circuits according to an embodiment of the present disclosure;
FIGS. 3 to 5 are views illustrating the system for detecting inter-cell short circuits according to the embodiment of the present disclosure;
FIGS. 6A and 6B are circuit diagrams illustrating an inter-cell short circuit according to the embodiment of the present disclosure;
FIG. 7 is a block diagram of a voltage measurement unit according to the embodiment of the present disclosure;
FIGS. 8A and 8B illustrate front and side views of a probe according to a first embodiment of the present disclosure;
FIGS. 9A and 9B illustrate front and side views of a probe according to a second embodiment of the present disclosure;
FIGS. 10A and 10B illustrate front and side views of a probe according to a third embodiment of the present disclosure;
FIG. 11 is a side view illustrating cell voltage measurement of the probe according to the third embodiment of the present disclosure; and
FIG. 12 is a flowchart for explaining a method of detecting inter-cell short circuits in secondary batteries according to an embodiment of the present disclosure.

### DETAILED DESCRIPTION

Example embodiments of the present disclosure will be described below in detail with reference to the accompanying drawings. Prior to the description, it is noted that the terms or words used in this specification and claims should not be construed as being limited to common or dictionary meanings but instead should be understood to have meanings and concepts in agreement with the scope of the present disclosure based on the principle that an inventor can define the concept of each term suitably in order to describe his/her own invention in the best way possible. Accordingly, since the embodiments described in this specification and the configurations illustrated in the drawings are only an example of the present disclosure and they do not cover all the technical ideas of the present disclosure, it should be understood that various changes and modifications may be made at the time of filing this application.

It will be further understood that the terms "comprises/includes" and/or "comprising/including" when used herein, specify the presence of stated features, integers, steps, operations, elements, components, and/or groups thereof, but do not preclude the presence or addition of one or more other features, integers, steps, operations, elements, components, and/or groups thereof.

In order to facilitate understanding of the present disclosure, the accompanying drawings are not drawn to scale and the dimensions of some components may be exaggerated. It should be noted that the same reference numerals are designated to the same components in different embodiments.

Reference to two compared elements, features, etc. as being "the same" means that they are "substantially the same". Therefore, the phrase "substantially the same" may include a deviation that is considered low in the art, for example, a deviation of 5% or less. The uniformity of any parameter in a given region may mean that it is uniform from an average perspective.

Although the terms such as "first" and/or "second" are used to describe various components, these components are not limited by these terms, of course. These terms are only used to distinguish one component from another component. Thus, unless specifically stated to the contrary, a first component may be termed a second component without departing from the teachings of example embodiments.

Throughout the specification, unless otherwise stated, each element may be singular or plural.

Arrangement of any component "above (or below)" or "on (or under)" a component may mean that any component is disposed in contact with the upper (or lower) surface of the component, as well as that other components may be interposed between the element and any element disposed on (or under) the element.

It will be understood that, when a component is referred to as being "connected", "coupled", or "joined" to another component, not only can it be directly "connected", "coupled", or "joined" to the other element, but also can it be indirectly "connected", "coupled", or "joined" to the other element with other elements interposed therebetween.

As used herein, the term "and/or" includes any and all combinations of one or more of the associate listed items. The use of "may" when describing embodiments of the present disclosure relates to "one or more embodiments of the present disclosure". Expressions such as "at least one" and "one or more" preceding a list of elements modify the entire list of elements and do not modify the individual elements in the list.

Throughout the specification, when "A and/or B" is stated, it means A, B, or A and B, unless otherwise stated. In addition, when "C to D" is stated, it means C or more and D or less, unless specifically stated to the contrary.

When the phrase such as "at least one of A, B, and C", "at least one of A, B, or C", "at least one selected from the group of A, B, and C", or "at least one selected from among A, B, and C" is used to designate a list of elements A, B, and C, the phrase may refer to any and all suitable combinations.

The term "use" may be considered synonymous with the term "utilize". As used herein, the terms "substantially," "about," and similar terms are used as terms of approximation rather than as terms of degree, and are intended to account for inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Accordingly, a first element, component, region, layer, or section discussed below may be termed a second element, component, region, layer, or section without departing from the teachings of example embodiments.

For ease of explanation in describing the relationship of one element or feature to another element(s) or feature(s) as illustrated in the drawings, spatially relative terms such as "beneath", "below", "lower", "above", and "upper" may be used herein. It will be understood that spatially relative positions are intended to encompass different directions of the device in use or operation in addition to the direction depicted in the drawings. For example, if the device in the drawings is turned over, any element described as being "below" or "beneath" another element would then be oriented "above" or "over" another element. Therefore, the term "below" may encompass both upward and downward directions.

The terminology used herein is for the purpose of describing embodiments of the present disclosure and is not intended to limit the present disclosure.

The present invention will be described in detail with reference to the attached drawings.

Examples of secondary batteries include a coin type, a cylindrical type, a prismatic type, and a pouch type. The present disclosure is basically applicable to a prismatic secondary battery. Therefore, the prismatic secondary battery will first be briefly described prior to description of embodiments of the present disclosure.

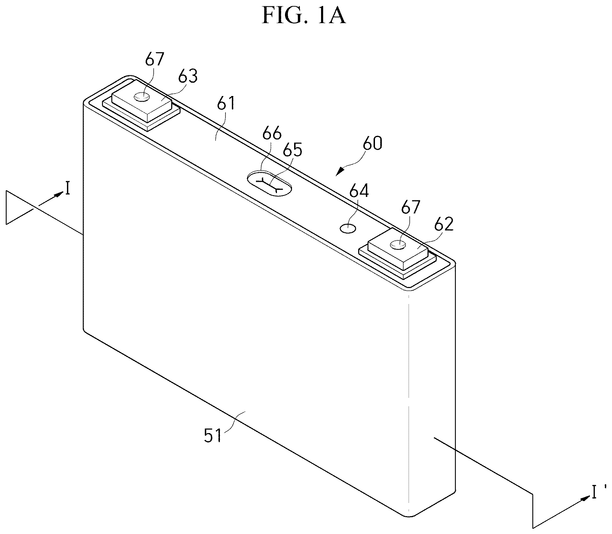

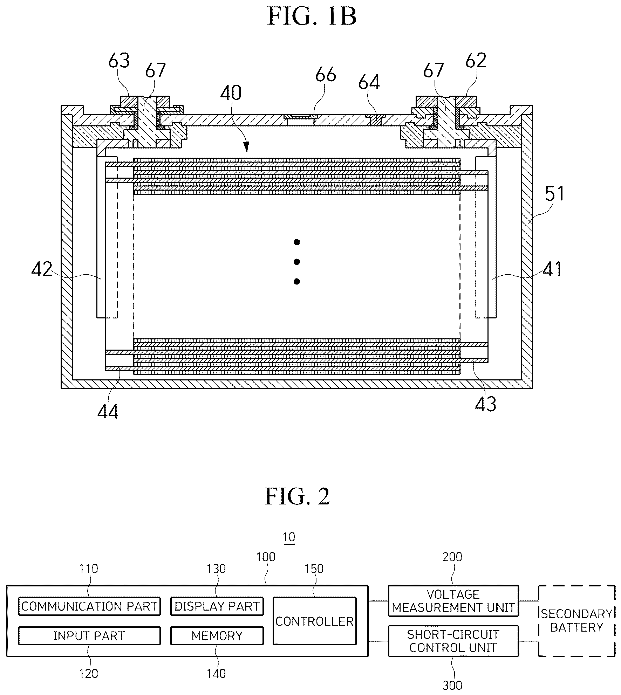

FIG. 1A is a top perspective view of the prismatic secondary battery. FIG. 1B is a cross-sectional view taken along line I-I' of FIG. 1A.

First, the external appearance of the prismatic secondary battery illustrated in FIG. 1A will be described.

A casing 51 defines an overall appearance of the prismatic secondary battery, and may be made of conductive metal, such as aluminum, aluminum alloy, or nickel-plated steel. In addition, the casing 51 may provide a space for accommodating an electrode assembly therein.

A cap assembly 60 may include a cap plate 61 that covers the opening of the casing 51, and the cap assembly 60 and the cap plate 61 may be made of a conductive material. Here, a first terminal 63 and a second terminal 62 may be electrically connected to respective positive and negative (or negative and positive) electrodes inside the casing, and may be installed to protrude outward through the cap plate 61.

The cap plate 61 may be equipped with an electrolyte injection port 64 formed to install a sealing plug, and a vent 66 formed with a notch 65. The vent 66 is for degassing the secondary battery, i.e., for discharging gas generated inside the secondary battery.

With reference to FIG. 1B, the internal structure of the prismatic secondary battery and the coupling structure with the cap assembly 60 will be described.

As illustrated in FIG. 1B, the prismatic secondary battery may basically include an electrode assembly 40, a first current collector part 41, a first terminal 62, a second current collector part 42, a second terminal 63, and a cap assembly 60.

The electrode assembly 40 may be formed by winding or stacking a laminate of a first electrode plate, a separator, and a second electrode plate, which are in the form of a plate or a film. When the electrode assembly 40 is a wound laminate, it may have a winding axis parallel to the longitudinal direction of the casing. The electrode assembly 40 may be of a stack type rather than a winding type, but the shape of the electrode assembly 40 is not limited in the present disclosure. In addition, the electrode assembly 40 may be a Z-stack electrode assembly in which a first electrode plate and a second electrode plate are inserted into both sides of a separator bent into a Z-stack. Furthermore, the electrode assembly 40 may consist of one or more electrode assemblies, which are stacked such that their long sides are adjacent to each other and accommodated in the casing, and the number of electrode assemblies is not limited in the present disclosure. The electrode assembly 40 may have a first electrode plate that acts as a negative electrode and a second electrode plate that acts as a positive electrode, or vice versa.

The first electrode plate may be formed by applying a first electrode active material, such as graphite or carbon, to a first electrode current collector plate made of metal foil, such as copper, copper alloy, nickel, or nickel alloy. The first electrode plate may include a first electrode tab (or first uncoated part) 43, which is a region without application of the first electrode active material. The first electrode tab 43 may act as a current flow passage between the first electrode plate and the first current collector part 41. In some examples, the first electrode tab 43 may be formed by cutting the first electrode plate to protrude to one side in advance when manufacturing the first electrode plate, and may protrude further to one side than the separator without separate cutting.

The second electrode plate may be formed by applying a second electrode active material such as transition metal oxide to a substrate made of metal foil, such as aluminum or aluminum alloy. The second electrode plate may include a second electrode tab (or second uncoated part) 44, which is a region without application of the second electrode active material. The second electrode tab 44 may act as a current flow passage between the second electrode plate and the second current collector part 42. In some examples, the second electrode tab 44 may be formed by cutting the second electrode plate to protrude to the other side in advance when manufacturing the second electrode plate, and may protrude further to the other side than the separator without separate cutting.

In some embodiments, the first electrode tab 43 may be located on the right end side of the electrode assembly 40, and the second electrode tab 44 may be located on the left end side of the electrode assembly 40. Alternatively, the first electrode tab 43 and the second electrode tab 44 may be located on one end side of the electrode assembly 40 in the same direction. Here, the left and the right are represented based on the secondary battery illustrated in FIG. 1 for convenience of explanation, and they may change in position when the secondary battery is rotated left and right or up and down.

The separator functions to prevent a short circuit between the first electrode plate and the second electrode plate while permitting migration of lithium ions therebetween. The separator may be made of, for example, a polyethylene film, a polypropylene film, a polyethylene-polypropylene film, or the like.

The first electrode tab 43 of the first electrode plate and the second electrode tab 44 of the second electrode plate extend from both ends of the electrode assembly 40 as described above, respectively. In some embodiments, the electrode assembly 40 may be accommodated together with an electrolyte in the casing 51.

In the electrode assembly 40, the first current collector part 41 and the second current collector part 42 may be welded and connected to the first electrode tab 43 extending from the first electrode plate and the second electrode tab 44 extending from the second electrode plate, respectively.

The first current collector part 41 and the second current collector part 42 are connected to the first terminal 62 and the second terminal 63, as described with reference to FIG. 1A, through terminal pins 67, respectively. In some embodiments, the terminal pins 67 may each have an outer peripheral surface that is threaded, and may be fastened to the first terminal 62 and the second terminal 63 by screwing. However, the present disclosure is not limited thereto. For example, the terminal pins 67 may also be coupled to the first terminal 62 and the second terminal 63 by riveting or welding.

FIG. 2 is a block diagram of a system for detecting inter-cell short circuits 10 according to an embodiment of the present disclosure.

Referring to FIG. 2, the system for detecting inter-cell short circuits 10 according to the embodiment of the present disclosure may include an inter-cell short-circuit detection unit 100, a voltage measurement unit 200, and a short-circuit control unit 300.

The inter-cell short-circuit detection unit 100 may determine whether a short circuit occurs between cells in a secondary battery by controlling the voltage measurement unit 200 and the short-circuit control unit 300.

The inter-cell short-circuit detection unit 100 may include a communication part 110, an input part 120, a display part 130, a memory 140, and a controller 150.

The communication part 110 may communicate with a user or administrator terminal over a network, and may communicate with a server that controls the system for detecting inter-cell short circuits 10. For this purpose, the communication part 110 may make use of Internet communication such as 5th generation (5G), long term evolution-advanced (LTE-A), long term evolution (LTE), and wireless fidelity (Wi-Fi).

The input part 120 generates input data in response to the input of an administrator that manages the system for detecting inter-cell short circuits 10. In particular, the input part 120 may receive, from the administrator, the specifications of the secondary battery for detecting inter-cell short circuits, the operation control signal of a probe 230 to be described later, etc. For this purpose, the input part 120 may include a key pad, a dome switch, a touch panel, a touch key, and a button.

The display part 130 outputs output data in response to the operation of the system for detecting inter-cell short circuits 10. In particular, the display part 130 may display current statuses of whether a short circuit occurs between cells in the secondary battery, which is detected by the system for detecting inter-cell short circuits 10, information on the short-circuited cells, etc. For this purpose, the display part 130 may include a liquid crystal display (LCD), a light emitting diode (LED) display, an organic light emitting diode (OLED) display, a micro-electro mechanical system (MEMS) display, and an electronic paper display.

The memory 140 stores programs for operation of the system for detecting inter-cell short circuits 10. In particular, the memory 140 may store an algorithm for determining whether there is an inter-cell short circuit by the controller 150, reference information for determining whether there is an inter-cell short circuit, an algorithm for controlling the operation of the voltage measurement unit 200, an algorithm for controlling the operation of the short-circuit control unit 300, etc.

The controller 150 may control the communication part 110, the input part 120, the display part 130, and the memory 140. The controller 150 may control the voltage measurement unit 200 and the short-circuit control unit 300 to determine whether a short circuit occurs between cells in the secondary battery.

For this purpose, the controller 150 may control the voltage measurement unit 200 to measure a first voltage between a first cell and a second cell in the secondary battery. The first voltage is a measured voltage of a normal module without any unique objects between the first cell and the second cell.

After controlling the voltage measurement unit 200 to measure the first voltage, the controller 150 may control the short-circuit control unit 300 to create a short circuit between the first cell and the second cell in the secondary battery. The method of causing a short circuit between the first cell and the second cell by the short-circuit control unit 300 will be described later. This allows the secondary battery to be simulated as a defective module with unique objects between the first cell and the second cell.

After controlling the short-circuit control unit 300 to create a short circuit between the first cell and second cell in the secondary battery, the controller 150 may control the voltage measurement unit 200 to measure a second voltage between the first cell and the second cell in the secondary battery. The second voltage is a measured voltage of the defective module with unique objects between the first cell and the second cell.

After controlling the voltage measurement unit 200 to measure the second voltage, the controller 150 may control the short-circuit control unit 300 to eliminate the short circuit between the first cell and the second cell in the secondary battery. This allows the secondary battery to be simulated as a normal module without any unique objects between the first cell and the second cell.

After eliminating the short circuit between the first cell and the second cell in the secondary battery, the controller 150 may control the voltage measurement unit 200 to measure a third voltage between the first cell and the second cell in the secondary battery. The third voltage is a measured voltage of the normal module without any unique objects between the first cell and the second cell.

The controller 150 may determine whether a short circuit occurs between the first cell and the second cell by using at least one of the first voltage, the second voltage, and the third voltage.

According to the embodiment of the present disclosure, the controller 150 may determine whether a short circuit occurs between cells in the secondary battery through various methods of determination.

In a first example, the controller 150 may determine whether there is an inter-cell short circuit based on whether the second voltage falls within a detection criterion. The controller 150 may determine that a short circuit occurs between the first cell and the second cell if the second voltage is less than a reference cell voltage. The reference cell voltage may be set according to the state of charge (SOC), and may set, for example, to be 3.5 V for the SOC of 30% or 3.7 V for the SOC of 50%. However, this is merely an example, and the reference cell voltage may be set differently depending on the condition of the secondary battery. Accordingly, the controller 150 may determine that no short circuit occurs between the first cell and the second cell if the second voltage is equal to the reference cell voltage. In embodiments where the controller 150 may determine whether there is an inter-cell short circuit based on whether the second voltage falls within a detection criterion, the controller may measure the second voltage without first measuring the first voltage and without subsequently measuring the third voltage.

In a second example, the controller 150 may determine whether there is an inter-cell short circuit based on whether the difference between the first voltage and the second voltage falls within a detection criterion. The controller 150 may determine that a short circuit occurs between the first cell and the second cell if the difference between the first voltage and the second voltage is less than a reference cell voltage. The reference cell voltage may be set according to the state of charge (SOC), and may set to be 3.5 V for the SOC of 30% or 3.7 V for the SOC of 50% as described above. Accordingly, the controller 150 may determine that no short circuit occurs between the first cell and the second cell if the difference between the first voltage and the second voltage is equal to the reference cell voltage.

In a third example, the controller 150 may determine whether there is an inter-cell short circuit based on whether the difference between the third voltage and the second voltage falls within a detection criterion. The controller 150 may determine that a short circuit occurs between the first cell and the second cell if the difference between the third voltage and the second voltage is less than a reference cell voltage. The reference cell voltage may be set according to the state of charge (SOC), and may set to be 3.5 V for the SOC of 30% or 3.7 V for the SOC of 50% as described above. Accordingly, the controller 150 may determine that no short circuit occurs between the first cell and the second cell if the difference between the third voltage and the second voltage is equal to the reference cell voltage.

The controller 150 may determine whether a short circuit occurs between the first cell and the second cell by using one of the first to third examples described above. Additionally or alternatively, the controller 150 may determine whether a short circuit occurs between the first cell and the second cell by using a combination of the first to third examples.

The controller 150 may control the display part 130 to output a result of short-circuit detection between the first cell and the second cell.

The controller 150 may determine and output whether a short circuit occurs between a second cell and a third cell in the secondary battery, whether a short circuit occurs between a third cell and a fourth cell in the secondary battery, etc., through the above-mentioned method. Thus, the controller 150 may ultimately detect a short circuit between cells in the secondary battery by determining whether a short circuit occurs between all respective cells in the secondary battery.

In addition, the controller 150 may control the operation of the voltage measurement unit 200 and short-circuit control unit 300.

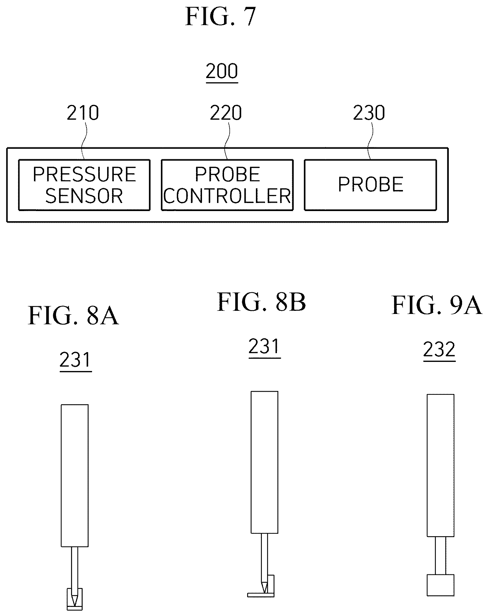

The voltage measurement unit 200 may measure a voltage between cells in the secondary battery, and a detailed description of the voltage measurement unit 200 will be given in FIG. 7 and other drawings.

The short-circuit control unit 300 may create or eliminate a short circuit between cells in the secondary battery.

The short-circuit control unit 300 may create an inter-cell short circuit in a variety of ways. In an embodiment of the present disclosure, the short-circuit control unit 300 may create an inter-cell short circuit by adding a specific resistance between cells in the secondary battery. For example, the short-circuit control unit 300 may add a resistance of 0.3 Ω to 5 kΩ between cells in the secondary battery. Conversely, the short-circuit control unit 300 may eliminate the inter-cell short circuit by eliminating the resistance added between cells in the secondary battery.

As described above, the cell of the secondary battery may be composed of a can that includes an external insulator. The short-circuit control unit 300 may create a short circuit by connecting the resistance added between cells to the can with external insulation completely removed. Additionally or alternatively, the short-circuit control unit 300 may create a short circuit by connecting the resistance added between cells to the can with external insulation partially removed.

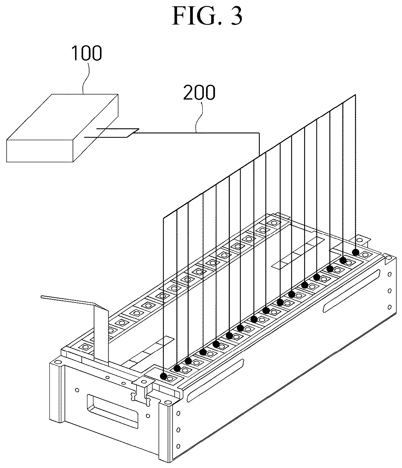

FIGS. 3 to 5 are views illustrating the system for detecting inter-cell short circuits 10 according to the embodiment of the present disclosure.

Referring to FIG. 3, the system for detecting inter-cell short circuits 10 according to the embodiment of the present disclosure includes the inter-cell short-circuit detection unit 100 and the voltage measurement unit 200, and the voltage measurement unit 200 may be connected to all cells of the secondary battery. Since the voltage measurement unit 200 is connected to all cells of the secondary battery, the inter-cell short-circuit detection unit 100 may control the voltage measurement unit 200 to measure a desired inter-cell voltage.

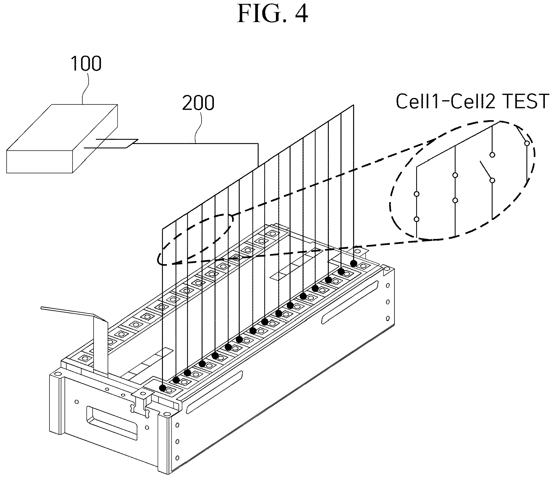

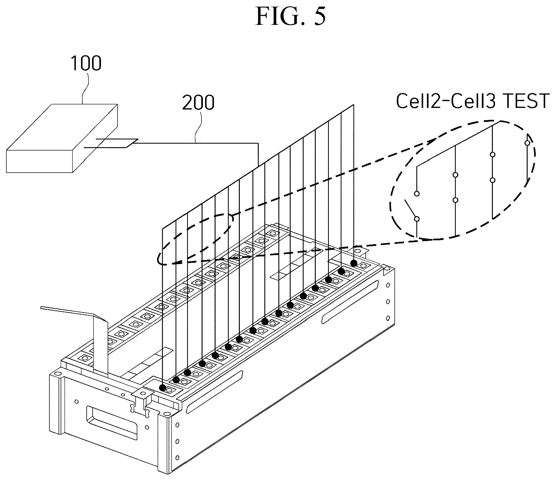

Referring to FIGS. 4 and 5, the voltage measurement unit 200 according to the embodiment of the present disclosure may include a switch part (not shown). The inter-cell short-circuit detection unit 100 may control the switch part (not shown) to easily measure a voltage between cells.

The switch part (not shown) may control the connection between the cells of the secondary battery and the voltage measurement unit 200. The switch part (not shown) may control the connection between the cells of the secondary battery and the voltage measurement unit 200 by controlling the inter-cell short-circuit detection unit 100, thereby measuring a desired inter-cell voltage.

As illustrated in FIG. 4, in order to measure the voltage between the first cell and the second cell, the switch part (not shown) may connect the voltage measurement unit 200 to the first and second cells and may disconnect the voltage measurement unit 200 from the remaining cells.

As illustrated in FIG. 5, in order to measure the voltage between the second cell and the third cell, the switch part (not shown) may connect the voltage measurement unit 200 to the second and third cells and may disconnect the voltage measurement unit 200 from the remaining cells.

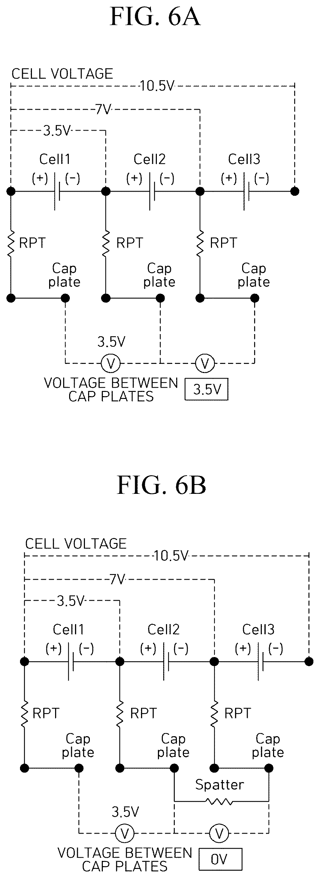

FIG. 6 is a circuit diagram illustrating an inter-cell short circuit according to the embodiment of the present disclosure.

FIG. 6(a) is a circuit diagram illustrating a normal module without any inter-cell short circuits in the secondary battery, and FIG. 6(b) is a circuit diagram illustrating a defective module with inter-cell short circuits in the secondary battery. As illustrated in FIG. 6(b), a short circuit may occur between cells by adding a specific resistance between the cells in the secondary battery.

As described above, the short-circuit control unit 300 may create or eliminate a short circuit between cells in the secondary battery. The short-circuit control unit 300 may create an inter-cell short circuit by adding a specific resistance between cells in the secondary battery. For example, the short-circuit control unit 300 may add a resistance of 0.3 Ω to 5 kΩ between cells in the secondary battery. Conversely, the short-circuit control unit 300 may eliminate the inter-cell short circuit by eliminating the resistance added between cells in the secondary battery. In addition, the cell of the secondary battery may be composed of a can that includes an external insulator. The short-circuit control unit 300 may create a short circuit by connecting the resistance added between cells to the can with external insulation completely removed. Additionally or alternatively, the short-circuit control unit 300 may create a short circuit by connecting the resistance added between cells to the can with external insulation partially removed.

FIG. 7 is a block diagram of the voltage measurement unit 200 according to the embodiment of the present disclosure.

Referring to FIG. 7, the voltage measurement unit 200 according to the embodiment of the present disclosure may include a pressure sensor 210, a probe controller 220, and a probe 230.

The pressure sensor 210 may be attached to one surface of the probe 230 to measure the pressure applied to one surface of the probe 230. The pressure sensor 210 may transmit the measured pressure information of the probe 230 to the probe controller 220.

The probe controller 220 may control the operation of the probe 230. The probe controller 220 may control the operation of the probe 230 such that the probe 230 comes into contact with the cell of the secondary battery. Specifically, the probe controller 220 may control the probe 230 to come into contact with the can constituting the cell of the secondary battery, thereby measuring an inter-cell voltage.

The probe controller 220 may control the operation of the probe 230 based on the pressure information of the probe 230 received through the pressure sensor 210. In other words, the probe controller 220 may control the operation of the probe 230 such that the probe 230 does not come into contact with the can constituting the cell of the secondary battery when exceeding a certain pressure. Thus, it is possible to measure a voltage between cells in the secondary battery without damaging the can constituting the cell of the secondary battery even if the probe comes into contact with the can constituting the cell of the secondary battery.

The probe 230 may measure an inter-cell voltage in the secondary battery while in contact with the cell of the secondary battery. The probe 230 may consist of at least two probes: a first probe 230 in contact with the first cell of the secondary battery; and a second probe 230 in contact with the second cell of the secondary battery. Accordingly, the probe 230 may measure the voltage between the first cell and the second cell.

The probe 230 may come into contact with the can constituting the cell of the secondary battery for voltage measurement. Specifically, the probe 230 may come into contact with the cap plate through the CMC hole of the can. Thus, it is possible to measure an inter-cell voltage by pressing the probe 230 onto cells without removing the external insulator beneath the cells.

The probe 230 may have various shapes for easy contact with cells. In other words, the probe 230 may have a shape that is efficient to come into contact with the cap plate through the CMC hole of the cell of the secondary battery. Hereinafter, the shape of the probe 230 will be described in relation to various embodiments.

FIGS. 8A and 8B illustrate front and side views of a probe 231 according to a first embodiment of the present disclosure. Referring to FIGS. 8A and 8B, the probe 231 according to the first embodiment of the present disclosure may have one surface, which comes into contact with a cell and has a " 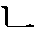 " shape.

The probe controller 220 may actuate the probe 231 according to the first embodiment to come into contact with the cap plate by passing through the CMC hole of the cell of the secondary battery and then moving from side to side.

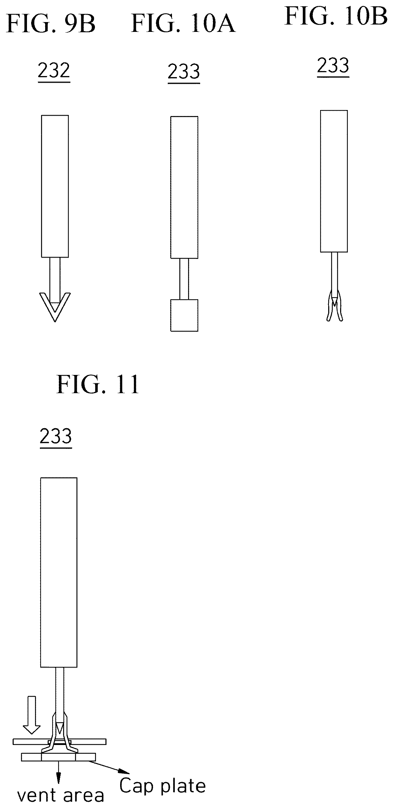

FIGS. 9A and 9B illustrate front and side views of a probe 232 according to a second embodiment of the present disclosure. Referring to FIGS. 9A and 9B, the probe 232 according to the second embodiment of the present disclosure may have one surface, which comes into contact with a cell and has a "V" shape.

The probe controller 220 may actuate the probe 232 according to the second embodiment to come into contact with the cap plate by passing through the CMC hole of the cell of the secondary battery and then tilting from side to side.

FIGS. 10A and 10B illustrate front and side views of a probe 233 according to a third embodiment of the present disclosure. Referring to FIGS. 10A and 10B, the probe 233 according to the third embodiment of the present disclosure may have one surface, which comes into contact with a cell and has a " 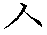 " shape. The " 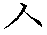 " shape, as shown in Figures 10A and 10B may also be understood as two outwardly curved prongs or legs connected at a point, the outward curves pointing downward. The outwardly curved prongs or legs may have a bend along their length.

The probe controller 220 may actuate the probe 233 according to the third embodiment to come into contact with the cap plate by passing through the CMC hole of the cell of the secondary battery and then moving up and down.

FIG. 11 is a side view illustrating cell voltage measurement of the probe 233 according to the third embodiment of the present disclosure. Referring to FIG. 11, as described above, it can be seen, through the control of the probe controller 220, that the probe 233 according to the third embodiment of the present disclosure comes into contact with the cap plate by passing through the CMC hole of the cell of the secondary battery and then moving up and down. The probe 233 according to the third embodiment may be configured such that the angle of its " 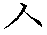 " shape increases as it comes into contact with the cap plate (or angle/curvature of the outwardly curving prongs/legs increases as the legs/prongs are splayed outward when in contact with the cap plate).

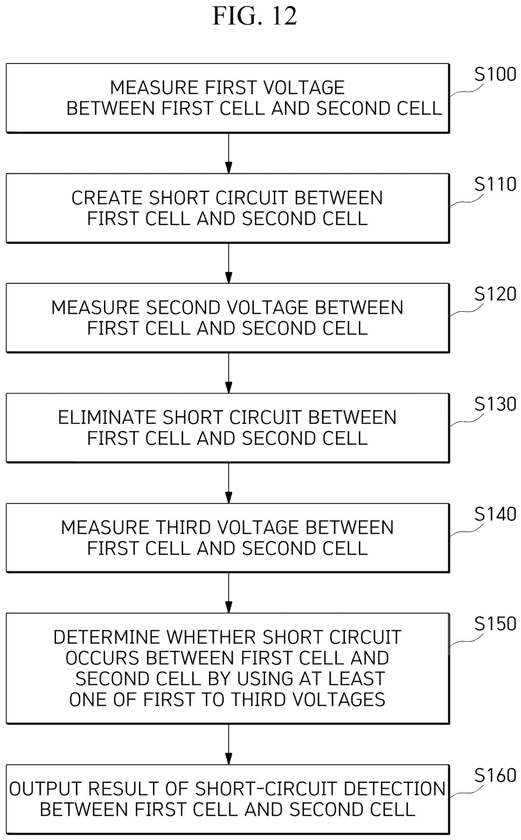

FIG. 12 is a flowchart for explaining a method of detecting inter-cell short circuits in secondary batteries according to an embodiment of the present disclosure.

Referring to FIG. 12, the method of detecting inter-cell short circuits in secondary batteries according to an embodiment of the present disclosure may include steps S100 to S160.

Step S100 is a step in which an inter-cell short-circuit detection unit 100 controls a voltage measurement unit 200 to measure a first voltage between a first cell and a second cell.

Step S110 is a step in which the inter-cell short-circuit detection unit 100 controls a short-circuit control unit 300 to create a short circuit between the first cell and the second cell.

Step S120 is a step in which the inter-cell short-circuit detection unit 100 controls the voltage measurement unit 200 to measure a second voltage between the first cell and the second cell.

Step S130 is a step in which the inter-cell short-circuit detection unit 100 controls a short-circuit control unit 300 to eliminate the short circuit between the first cell and the second cell.

Step S140 is a step in which the inter-cell short-circuit detection unit 100 controls the voltage measurement unit 200 to measure a third voltage between the first cell and the second cell.

Step S150 is a step in which the inter-cell short-circuit detection unit 100 determines whether a short circuit occurs between the first cell and the second cell by using at least one of the first voltage, the second voltage, and the third voltage.

Step S160 is a step in which the inter-cell short-circuit detection unit 100 controls a display part 130 to output a result of short-circuit detection between the first cell and the second cell.

The method of detecting inter-cell short circuits in secondary batteries according to the embodiment of the present disclosure has been described above with reference to the flowchart presented in the drawing. For the purposes of simplicity, the method has been illustrated and described as a series of blocks, but the present disclosure is not limited to the order of the blocks. In addition, some blocks may occur in a different order or concurrently with other blocks than illustrated and described herein, and various different branches, flow paths, and sequences of blocks may be implemented that achieve the same or similar results. Furthermore, all of the blocks illustrated may not be required to implement the method described herein.

Meanwhile, in the description with reference to FIG. 12, each step may be further divided into additional steps or combined into fewer steps, depending on the implementation of the present disclosure. Additionally, if necessary, some steps may be omitted or the order between steps may be changed. Moreover, even if there are any other omitted, the contents of FIGS. 1A to 11 may be applied to the contents of FIG. 12. On the other hands, the contents of FIG. 12 may be applied to the contents of FIGS. 1A to 11.

Hereinafter, materials which may be used in a secondary battery according to an embodiment of the present disclosure are described.

A compound (e.g., a lithiated intercalation compound) capable of reversible intercalation and deintercalation of lithium may be used as a positive electrode active material. Specifically, one type or more selected among complex oxides of metal, selected among cobalt, manganese, nickel, and a combination of them, and lithium may be used as the positive electrode active material.

The complex oxide may be lithium transition metal complex oxide. A detailed example of the complex oxide may include lithium nickel-based oxide, lithium cobalt-based oxide, lithium manganese-based oxide, a lithium ferrous phosphate-based compound, cobalt-free nickel-manganese-based oxide, or a combination of them.

For example, a compound that is represented as one of the following chemical formulas may be used. LiₐA_{1-b}X_{b}O_{2-c}D_{c} (0.90≤a≤1.8, 0≤b≤0.5, 0≤c≤0.05); LiₐMn_{2-b}X_{b}O_{4-c}D_{c} (0.90≤a≤1.8, 0≤b≤0.5, 0≤c≤0.05); LiₐNi_{1-b-c}CO_{b}X_{c}O_{2-α}D_{α} (0.90≤a≤1.8, 0≤b≤0.5,0≤c≤0.5, 0≤α≤2); LiₐNi_{1-b-c}Mn_{b}X_{c}O_{2-α}D_{α} (0.90≤a≤1.8, 0≤b≤0.5,0≤c≤0.5, 0<α<2); LiₐNi_{b}Co_{c}L¹_{d}GₑO₂ (0.90≤a≤1.8, 0≤b≤0.9, 0≤c≤0.5, 0≤d≤0.5, 0≤e≤0.1); LiₐNiG_{b}O₂ (0.90≤a≤1.8, 0.001≤b≤0.1); LiₐCoG_{b}O₂ (0.90≤a≤1.8, 0.001≤b≤0.1); LiₐMn_{1-b}G_{b}O₂(0.90≤a≤1.8, 0.001≤b≤0.1); LiₐMn₂G_{b}O₄(0.90≤a≤1.8, 0.001≤b≤0.1); LiₐMn_{1-g}G_{g}PO₄(0.90≤a≤1.8, 0≤g≤0.5); Li_{(3-f)}Fe₂(PO₄)₃(0≤f≤2); and LiₐFePO₄(0.90≤a≤1.8).

In the chemical formula, A may be Ni, Co, Mn, or a combination of them. X may be Al, Ni, Co, Mn, Cr, Fe, Mg, Sr, V, a rare earth element, or a combination of them; D may be O, F, S, P, or a combination of them. G may be Al, Cr, Mn, Fe, Mg, La, Ce, Sr, V, or a combination of them. L¹ may be Mn, Al, or a combination of them.

A positive electrode for a lithium secondary battery may include a current collector and a positive electrode active material layer formed on the current collector. The positive electrode active material layer may include the positive electrode active material, and may further include a binder and/or a conductive material.

Content of the positive electrode active material may be 90 wt.% to 99.5 wt.% with respect to the positive electrode active material layer 100 wt.%. Content of the binder and the conductive material may be 0.5 wt.% to 5 wt.% with respect to the positive electrode active material layer 100 wt.%.

Al may be used as the current collector, but the present disclosure may not be limited thereto.

A negative electrode active material may include a material capable of reversibly Intercalation/de-intercalation with respect to lithium ions, lithium metal, an alloy of lithium metal, a material capable of doping and dedoping with respect to lithium, or transition metal oxide.

The material capable of reversibly Intercalation/de-intercalation with respect to lithium ions may include a carbon-based negative electrode active material, for example, crystalline carbon, amorphous carbon, or a combination of them. An example of the crystalline carbon may include graphite, such as natural graphite or synthetic graphite. Examples of the amorphous carbon may include soft or hard carbon, mesophase pitch carbide, and fired coke.

An Si-based negative electrode active material or an Sn-based negative electrode active material may be used as the material capable of doping and dedoping with respect to lithium. The Si-based negative electrode active material may be silicon, a silicon-carbon composite, SiOₓ (0<x<2), a Si-based alloy, or a combination of them.

The silicon-carbon composite may be a composite of silicon and amorphous carbon. According to an implementation example, the silicon-carbon composite may include silicon particles, and may have a form in which amorphous carbon has been coated on surfaces of silicon particles.

The silicon-carbon composite may further include crystalline carbon. For example, the silicon-carbon composite may include a core including crystalline carbon and silicon particles, and an amorphous carbon coating layer disposed on a surface of the core.

A negative electrode for a lithium secondary battery may include a current collector and a negative electrode active material layer disposed on the current collector. The negative electrode active material layer may include the negative electrode active material, and may further include a binder and/or a conductive material.

For example the negative electrode active material layer may include the negative electrode active material of 90 wt.% to 99 wt.%, the binder of 0.5 wt.% to 5 wt.%, and the conductive material of 0 wt.% to 5 wt.%.

A nonaqueous-based binder, an aqueous-based binder, a dry binder, or a combination of them may be used as the binder. If the aqueous-based binder is used as a binder for the negative electrode, the binder for the negative electrode may further include a cellulose-series compound capable of assigning viscosity.

One selected among nickel foil, stainless steel foil, titanium foil, nickel foam, copper foam, a polymer base on which a conductive metal has been coated, and a combination of them may be used as a current collector for the negative electrode.

An electrolyte for a lithium secondary battery may include a nonaqueous organic solvent and lithium salts.

The nonaqueous organic solvent may play a role as a medium through which ions that are involved in an electrochemical reaction of a battery can move.

The nonaqueous organic solvent may be a carbonate-based, ester-based, ether-based, ketone-based, or alcohol-based solvent, an aprotic solvent, or a combination of them. The carbonate-based, ester-based, ether-based, ketone-based, or alcohol-based solvent, or the aprotic solvent may be used solely, or two types or more of them may be mixed and used as the nonaqueous organic solvent.

Furthermore, if the carbonate-based solvent is used, annular carbonate and chain carbonate may be mixed and used.

A separator may be present between the positive electrode and the negative electrode depending on the type of lithium secondary battery. Polyethylene, polypropylene, and polyvinylidene fluoride, or a multi-layer having two or more layers of them may be used as the separator.

The separator may include a porous base, and a coating layer including an organic matter, an inorganic matter, or a combination of them that is disposed on one or both sides of the porous base.

The organic matter may include a polyvinylidene fluoride-based heavy antibody or (meth)acrylic polymer.

The inorganic matter may include inorganic particles selected among Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and a combination of them, but the present disclosure is not limited thereto.

The organic matter and the inorganic matter may have a form in which the organic matter and the inorganic matter have been mixed in one coating layer or a form in which a coating layer including the organic matter and a coating layer including the inorganic matter have been stacked.

As is apparent from the above description, according to the embodiments of the present disclosure, it is possible to clearly distinguish whether there is an inter-cell short circuit when a short circuit occurs between cells, which can greatly reduce the possibility of detection errors and ensure the reliability of detection results.

According to the embodiments of the present disclosure, it is possible to detect an inter-cell short circuit regardless of the size of inter-cell short-circuit resistance.

The present disclosure can be utilized not only for inspecting a secondary battery module that has been assembled, but also for inspecting an in-line process.

According to the embodiments of the present disclosure, since inspection is possible with simple measuring equipment without the use of chargers/dischargers, it is possible to reduce the time and cost required for detecting inter-cell short circuits.

However, aspects and features of the present disclosure are not limited to those described above, and other aspects and features not mentioned will be clearly understood by a person skilled in the art from the detailed description, described below.

Although the present disclosure has been described above in connection with the limited embodiments and drawings, the present disclosure is not limited to the embodiments. A person having ordinary knowledge in the art to which the present disclosure pertains may modify and change the present disclosure within the technical scope of the present disclosure and the equivalent range of the following claims.

## Claims

1. A system for detecting inter-cell short circuits in secondary batteries, comprising:
a voltage measurement unit configured to comprise a probe that comes into contact with a cell of a secondary battery to measure an inter-cell voltage;
a short-circuit control unit configured to control an inter-cell short circuit; and
an inter-cell short-circuit detection unit configured to control the voltage measurement unit to measure a first voltage between a first cell and a second cell in the secondary battery, to control the short-circuit control unit to create a short circuit between the first cell and the second cell, to control the voltage measurement unit to measure a second voltage between the first cell and the second cell, to control the short-circuit control unit to eliminate the short circuit between the first cell and the second cell, to control the voltage measurement unit to measure a third voltage between the first cell and the second cell, and to determine whether a short circuit occurs between the first cell and the second cell by using at least one of the first voltage, the second voltage, and the third voltage.

2. The system as claimed in claim 1, wherein the inter-cell short-circuit detection unit determines whether a short circuit occurs between the first cell and the second cell based on whether the second voltage falls within a preset cell voltage criterion.

3. The system as claimed in claim 1 or claim 2, wherein the inter-cell short-circuit detection unit determines whether a short circuit occurs between the first cell and the second cell based on whether a difference between the first voltage and the second voltage falls within a preset cell voltage criterion.

4. The system as claimed in any one of claims 1 - 3, wherein the inter-cell short-circuit detection unit determines whether a short circuit occurs between the first cell and the second cell based on whether a difference between the third voltage and the second voltage falls within a preset cell voltage criterion.

5. The system as claimed in any preceding claim, wherein the probe has a " 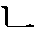 " shape.

6. The system as claimed in any one of claims 1 - 4, wherein the probe has a "V" shape.

7. The system as claimed in any one of claims 1 - 4, wherein the probe has a " 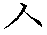 " shape.

8. The system as claimed in any preceding claim, wherein the voltage measurement unit further comprises:
a pressure sensor attached to one surface of the probe to measure a pressure applied to one surface of the probe; and
a probe controller configured to control the operation of the probe such that the probe comes into contact with the cell at a preset pressure or less.

9. The system as claimed in claim 8, wherein the probe controller controls the operation of the probe such that the probe comes into contact with a cap plate through a CMC hole of a can constituting the cell.

10. The system as claimed in any preceding claim, wherein the short-circuit control unit creates a short circuit by adding a specific resistance between the first cell and the second cell.

11. A method of detecting inter-cell short circuits in secondary batteries, which is performed by a system for detecting inter-cell short circuits in secondary batteries, the system comprising a voltage measurement unit configured to comprise a probe that comes into contact with a cell of a secondary battery to measure an inter-cell voltage and a short-circuit control unit configured to control an inter-cell short circuit, the method comprising:
controlling the voltage measurement unit to measure a first voltage between a first cell and a second cell in the secondary battery;
controlling the short-circuit control unit to create a short circuit between the first cell and the second cell;
controlling the voltage measurement unit to measure a second voltage between the first cell and the second cell;
controlling the short-circuit control unit to eliminate the short circuit between the first cell and the second cell;
controlling the voltage measurement unit to measure a third voltage between the first cell and the second cell; and
determining whether a short circuit occurs between the first cell and the second cell by using at least one of the first voltage, the second voltage, and the third voltage.

12. The method as claimed in claim 11, wherein whether a short circuit occurs between the first cell and the second cell is determined based on whether the second voltage falls within a preset cell voltage criterion.

13. The method as claimed in claim 11 or claim 12, wherein whether a short circuit occurs between the first cell and the second cell is determined based on whether a difference between the first voltage and the second voltage falls within a preset cell voltage criterion.

14. The method as claimed in any one of claims 11 - 13, wherein whether a short circuit occurs between the first cell and the second cell is determined based on whether a difference between the third voltage and the second voltage falls within a preset cell voltage criterion.

15. The method as claimed in any one of claims 11 - 14, wherein:
the voltage measurement unit further comprises a pressure sensor attached to one surface of the probe to measure a pressure applied to one surface of the probe, and a probe controller configured to control the operation of the probe; and
the probe controller controls the operation of the probe such that the probe comes into contact with the cell at a preset pressure or less.
